Europäisches Patentamt

European Patent Office

Office européen des brevets

(19)

(11) Veröffentlichungsnummer: **0 220 469**
B1

(12) **EUROPÄISCHE PATENTSCHRIFT**

(45) Veröffentlichungstag der Patentschrift:
06.12.89

(21) Anmeldenummer: 86112866.8

(22) Anmeldetag: 17.09.86

(51) Int. Cl.⁴: **H01L 29/52**, H01L 29/743

(54) Leistungsthyristor.

(30) Priorität: 15.10.85 DE 3536726

(43) Veröffentlichungstag der Anmeldung:
06.05.87 Patentblatt 87/19

(45) Bekanntmachung des Hinweises auf die Patenterteilung:
06.12.89 Patentblatt 89/49

(84) Benannte Vertragsstaaten:
DE FR GB SE

(56) Entgegenhaltungen:
EP-A- 0 064 231
EP-A- 0 077 930
DE-A- 2 847 853
FR-A- 2 075 910
FR-A- 2 254 879
US-A- 4 096 623

(73) Patentinhaber: **Siemens Aktiengesellschaft,
Wittelsbacherplatz 2, D-8000 München 2(DE)**

(72) Erfinder: **Gross, Wolfgang, Dr., Münchnerstrasse 111a,
D-8043 Unterföhring(DE)**

ACTORUM AG

## Beschreibung

Die Erfindung bezieht sich auf einen Leistungsthyristor mit einem Halbleiterkörper mit den Merkmalen:

a) Der Halbleiterkörper hat zwei mit Metallelektroden versehene Hauptflächen,

b) auf mindestens einer der Hauptflächen sind mindestens zwei Elektroden angeordnet,

c) die Kontaktfläche der ersten dieser zwei Elektroden liegt in einer ersten zur Hauptfläche parallelen Ebene,

d) die Kontaktfläche der zweiten dieser zwei Elektroden liegt in einer zweiten zur Hauptfläche parallelen Ebene,

e) die genannte Hauptfläche ist plan ausgebildet,

f) die Kontaktfläche der ersten Elektrode ist von der Hauptfläche weiter entfernt als die Kontaktfläche der zweiten Elektrode.

g) die erste Elektrode besteht aus zwei Schichten,

h) auf der ersten, an die Hauptfläche angewendenen Schicht sitzt eine Metallschicht,

i) die Metallschicht besteht aus dem gleichen Metall und ist gleich dick wie die zweite Elektrode.

Ein solcher Leistungsthyristor, bei dem beide Schichten der ersten Elektrode aus demselben Metall, z.B. Aluminium, bestehen, ist aus FR-A 2 254 879 bekannnt.

Ein weiterer Leistungsthyristor ist beispielsweise in der DE-A 2 431 506 beschrieben worden. Dieser Thyristor hat eine innere Zündverstärkung, d. h. einen Hilfsemitter und einen Hauptemitter. Der Hauptemitter und der Hilfsemitter ist mit einer ersten bzw. zweiten Elektrode versehen. Die Hilfsemitterelektrode ist dünner als die Hauptemitterelektrode ausgebildet, so daß die Hauptemitterelektrode auf einfache Weise von einer plan ausgebildeten katodenseitigen Kontaktelektrode kontaktiert werden kann, ohne die Hilfsemitterelektrode zu berühren.

Die geringere Dicke der Hilfsemitterelektrode wird dadurch erreicht, daß zunächst auf dem Halbleiterkörper eine durchgehende Metallschicht aufgebracht wird, daß dann die Elektroden strukturiert werden und daß dann das Metall der Hilfsemitterelektrode dünner geätzt wird. Dies erfordert eine Vielzahl von Maskierungsschritten. Außerdem hat diese Anordnung den Nachteil, daß die Querleitfähigkeit der Hilfsemitterelektrode verringert wird. Außerdem ist das Ätzen von Metallschichten nicht einfach, weil es hier zu relativ starken Unterätzungen der Ätzmaske kommt. Damit ist man jedoch auf relativ grobe Strukturen beschränkt.

Der Erfindung liegt die Aufgabe zugrunde, einen Leistungsthyristor der eingangs erwähnten Art so weiterzubilden, daß die unterschiedliche Höhe der genannten Kontaktflächen auf einfache Weise herstellbar ist. Außerdem soll die Herstellung wesentlich feinerer Strukturen als bisher ohne großen Aufwand möglich sein.

Diese Aufgabe wird gelöst durch das Merkmal:

k) die erste, an die Hauptfläche angrenzende Schicht besteht aus polykristallinem Silicium.

Weiterbildungen sind Gegenstand der Unteransprüche.

Die Erfindung wird anhand von Ausführungsbeispielen in Verbindung mit den Fig. 1 bis 10 näher erläutert. Es zeigen:

Fig. 1 einen Schnitt durch ein erstes Ausführungsbeispiel,

Fig. 2 einen teilweisen Schnitt durch ein zweites Ausführungsbeispiel,

Fig. 3 und 4 je eine Aufsicht auf zwei Elektrodenkonfigurationen der Anordnung nach Fig. 1,

Fig. 5 bis 10 wesentliche Verfahrensschritte zur Herstellung der Anordnung nach Fig. 1.

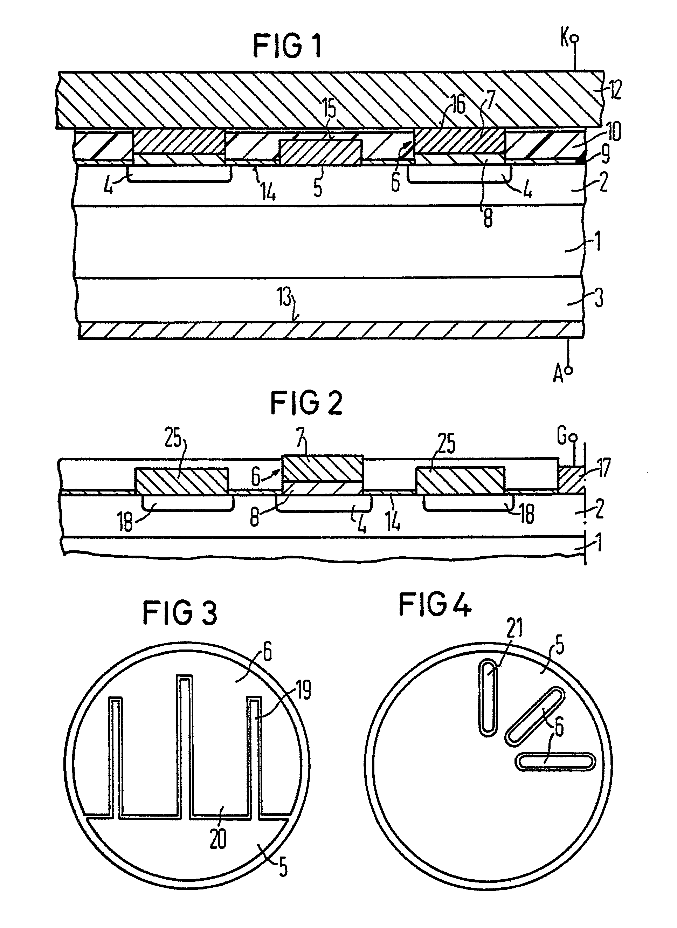

Der Halbleiterkörper des Leistungsthyristors nach Fig. 1 hat eine Mittelzone 1, an die eine katodenseitige Basiszone 2 und eine anodenseitige Emitterzone 3 angrenzt. Der Halbleiterkörper hat eine anodenseitige Hauptfläche 13 und eine katodenseitige Hauptfläche 14. In die katodenseitige Hauptfläche 14 ist eine Emitterzone 4 planar eingebettet. Die Zonen 4 und 2 sind mit einer ersten Elektrode 6 bzw. mit einer zweiten Elektrode 5 versehen. Die Kontaktfläche 16 der ersten Elektrode 6 ist weiter von der Hauptfläche 14 entfernt als die Kontaktfläche 15 der zweiten Elektrode 5. Die erste Elektrode 6 hat zwei Schichten 7, 8. Die erste, auf der Hauptfläche 14 aufsitzende Schicht 8 besteht aus polykristallinem Silicium. Sie ist beispielsweise 5 bis 10 µm stark. Die zweite, auf der ersten Schicht 8 sitzende Schicht 7 besteht aus dem gleichen Metall wie die zweite Elektrode 5 und hat die gleiche Dicke wie diese. Sie besteht beispielsweise aus Aluminium. Im übrigen ist die Hauptfläche 14 mit einer Siliciumdioxidschicht 9 bedeckt.

Die erste Elektrode 6 bildet die Katodenelektrode des Leistungsthyristors und ist von einer katodenseitigen Zuführungselektrode 12 kontaktiert. Diese Zuführungselektrode ist an ihrer dem Halbleiterkörper zugewandten Seite plan ausgebildet. Ein Kontakt mit der die Gateelektrode bildenden Elektrode 5 wird durch deren im Vergleich zur Elektrode 6 geringere Dicke vermieden. Da die Polysiliciumschicht 8 nur eine Dicke zwischen 5 und 10 µm hat, liegt auch zwischen der Elektrode 5 und der Zuführungselektrode 12 nur ein Abstand von 5 bis 10 µm. Da zwischen den Elektroden 5 und 6 eine Potentialdifferenz von z. B. 20 V liegt, reicht dieser Abstand zur Isolation aus. Insbesondere bei Druckkontakten ist es jedoch zweckmäßig, die Elektrode 5 und den Zwischenraum zwischen den Elektroden 5 und 6 mit einer Isolierschicht 10 zu bedecken. Als Isoliermaterial hat sich hierfür ein Fotoimid bewährt, das unter dem Namen "Selectilux HTR 3" der Firma Merck im Handel ist. Die Schicht 10 wird bis zu einer Dicke aufgebracht, die die Kontaktfläche der Elektrode 6 freiläßt und die Elektrode 6 nur am Rand umgibt.

Der Leistungsthyristor nach Fig. 1 kann beispielsweise ein GTO-Thyristor sein. Bei einem solchen Thyristor muß sowohl die Breite der Emitterzone 4 als auch der Abstand der einzelnen Emitterzonenteile untereinander möglichst gering sein. Damit läßt sich verhindern, daß der GTO-Thyristor bei Ausräumen der Speicherladung erneut gezündet wird. Auch läßt sich die Freiwerdezeit damit verkürzen.

Mögliche Ausführungsformen für die Gestaltung der Elektroden 5 und 6 sind in den Fig. 3 und 4 dargestellt. Die Darstellungsweise ist hier der besseren Übersichtlichkeit halber stark vergröbert. Im Ausführungsbeispiel nach Fig. 3 sind die ersten und zweiten Elektroden 6, 5 fingerförmig ausgebildet und so angeordnet, daß sich ihre Finger 19 bzw. 20 verzahnen. Die Finger 19, 20 bleiben dabei jeweils mechanisch und elektrisch miteinander verbunden.

Im Ausführungsbeispiel nach Fig. 4 sind die Emitterelektroden 6 als inselförmige Bereiche in Aussparungen 21 der Gateelektrode 5 angeordnet. Sie sind sowohl mechanisch als auch elektrisch voneinander getrennt und werden erst durch die Zuführungselektrode 12 elektrisch miteinander verbunden. Die Inseln können streifenförmig oder punktförmig ausgebildet sein.

Die Erfindung ist nicht auf einen GTO-Thyristor beschränkt, sondern kann beispielsweise auch bei einem Thyristor mit innerer Zündverstärkung verwendet werden, der in Fig. 2 dargestellt ist. Gleiche Bezugszeichen bezeichnen hier gleiche Teile wie in Fig. 1. Der Thyristor nach Fig. 2 weist zusätzlich Hilfsemitterzonen 18 auf, die ebenso wie die Emitterzonen 4 in die Hauptfläche 14 des Thyristors eingebettet sind. Der Hilfsemitter 16 ist mit einer Hilfsemitterelektrode 25 versehen. Die Zone 2 ist mit einer Elektrode 17 versehen, die den Gateanschluß G bildet.

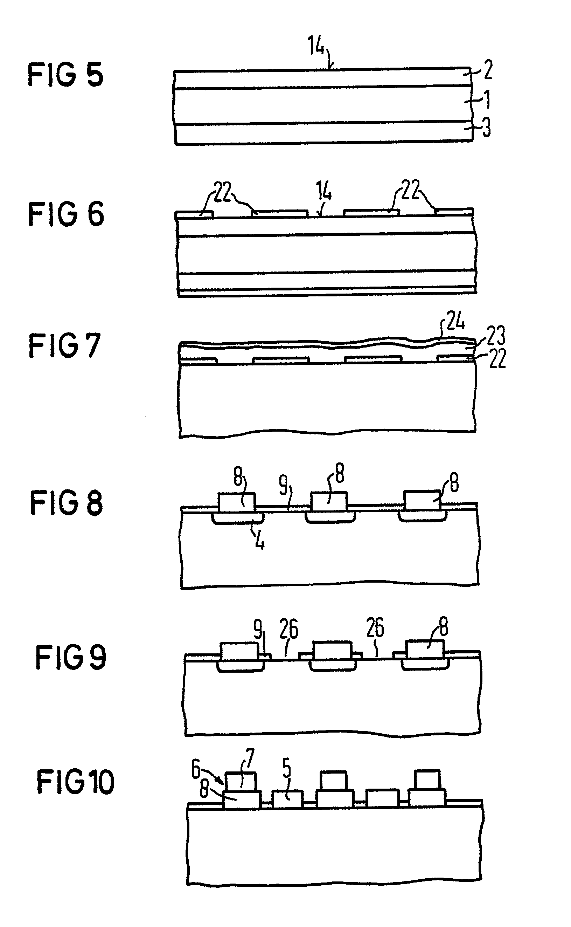

Der GTO-Thyristor läßt sich durch ein einfaches Verfahren herstellen, das anhand markanter Verfahrensschritte in den Fig. 5 bis 10 dargestellt ist. Der Halbleiterkörper wird zunächst einer Grunddiffusion unterworfen, bei dem die Zonen 1, 2 und 3 entstehen (Fig. 5). Anschließend wird die Oberfläche des Halbleiterkörpers oxidiert und auf der katodenseitigen Hauptfläche 14 strukturiert, wobei Siliciumdioxidschichten 22 stehenbleiben (Fig. 6). Beim nächsten Schritt wird katodenseitig eine Schicht 23 aus polykristallinem Silicium abgeschieden. Dies geschieht zweckmäßig durch ein CVD-Verfahren. Nach Abscheiden der polykristallinen Siliciumschicht von 5 bis 10 μm Stärke wird deren Oberfläche mit einem Dotierstoff, z. B. mit Phosphor, belegt, so daß eine durchgehende Phosphorschicht 24 entsteht (Fig. 7).

Anschließend wird die polykristalline Siliciumschicht 23 fototechnisch derart strukturiert, daß das polykristalline Silicium lediglich in den von den Dioxidschichten 22 nicht bedeckten Teilen erhalten bleibt. Dort bildet die polykristalline Siliciumschicht die erste Schicht 8 der Emitterkontakte (Fig. 8). Anschließend wird der Phosphor der Schicht 24 in den Halbleiterkörper eindiffundiert und bildet die Emitterzonen. Sodann werden in der Siliciumdioxidschicht 9 Öffnungen 26 erzeugt, die für die zweiten Elektroden 5 bestimmt sind (Fig. 9).

Als nächster Schritt wird dann auf die Katodenseite eine Aluminiumschicht aufgebracht, die sich sowohl auf die erste Schicht 8 der ersten Kontakte als auch in die Öffnungen 24 legt. Durch einen weiteren Fotoschritt werden die zweiten Schichten 7 der ersten Kontakte 6 und die zweiten Kontakte 5 strukturiert.

Die Strukturen können sehr fein ausgebildet werden, wobei die lateralen Abmessungen der Emitter und ihre Abstände voneinander in der Größenordnung zwischen 50 und 200 μm liegen können. Dies ist hauptsächlich deswegen möglich, weil das polykristalline Silicium wegen der geringeren Unterätzung der Ätzmaske wesentlich präziser geätzt werden kann als Metall. Dadurch, daß die polykristalline Siliciumschicht als Dotierstoffquelle für die Emitterzonen 4 dient, scheiden Justierfehler aus, die bei der Verwendung von Metallelektroden entsprechende Toleranzen notwendig machen. Bei der Herstellung des Thyristors nach Fig. 2 müssen die Emitterzonen vor dem Aufbringen der polykristallinen Siliciumschicht erzeugt werden, da die Hilfsemitterkontakte einen Nebenschluß zur Basiszone 2 bilden müssen. Durch die Dotierung des polykristallinen Siliciums wird der Bahnwiderstand in den Kontakten klein gehalten. Wird die polykristalline Siliciumschicht be reits während der Abscheidung sehr hoch dotiert, so wird die in die Emitterzonen 4 eindringende Menge an Dotierstoff durch dessen Löslichkeit im Halbleiterkörper 1 bestimmt. Auf diese Weise können sehr gleichmäßige Dotierungsverhältnisse erzeugt werden.

Bezugszeichenliste

    1 = Mittelzone
    2 = katodenseitige Basiszone
    3 = anodenseitige Emitterzone
    4 = Emitterzone
    5, 6 = Elektrode
    7, 8 = Schicht
    9 = Siliumdioxidschicht
    10 = Isolierschicht
    12 = Zuführungselektrode
    13 = anodenseitige Hauptfläche
    14 = katodenseitige Hauptfläche
    15, 16 = Kontaktfläche
    18 = Hilfsemitterzone
    19, 20 = Finger
    21 = Ausspannung
    22 = Dioxidschicht
    23 = Siliciumschicht
    24 = Phosphorschicht
    26 = Öffnung

**Patentansprüche**

1. Leistungsthyristor mit einem Halbleiterkörper mit den Merkmalen:
    a) Der Halbleiterkörper hat zwei mit Metallelektroden versehene Hauptflächen (13, 14),
    b) auf mindestens einer (14) der Hauptflächen sind mindestens zwei Elektroden (5, 6) angeordnet,
    c) die Kontaktfläche (16) der ersten (6) dieser zwei Elektroden liegt in einer ersten zur Hauptfläche (14) parallelen Ebene,

d) die Kontaktfläche (15) der zweiten (5) dieser zwei Elektroden liegt in einer zweiten zur Hauptfläche (14) parallelen Ebene,

e) die genannte Hauptfläche (14) ist plan ausgebildet,

f) die Kontaktfläche (16) der ersten Elektrode (6) ist von der Hauptfläche (14) weiter entfernt als die Kontaktfläche (15) der zweiten Elektrode (5),

**g) die ersten Elektrode (6) betseht aus zwei Schichten (7, 8),**

**h) auf der ersten an die Hauptfläche (14) angewendeten Schicht, (8) sitzt eine Metallschicht (7), gekennzeichnet** durch die Merkmale:

i) die Metallschicht (7) besteht aus dem gleichen Metall und ist gleich dick wie die zweite Elektrode (5).

k) die erste, an die Hauptfläche (14) angrenzende Scxhicht (8) besteht aus der polykristallinem Silicium.

2. Leistungsthyristor nach Anspruch 1, **dadurch gekennzeichnet**, daß das Metall Aluminium ist.

3. Leistungsthyristor nach Anspruch 1 oder 2, **dadurch gekennzeichnet**, daß die Hauptfläche (14) und die zweite Elektrode (5) mit einer Isolierschicht (9) aus einem Polyimid bedeckt ist, daß die Isolierschicht die erste Elektrode (6) umgibt und lediglich ihre Kontaktfläche (16) freiläßt.

4. Leistungsthyristor nach einem der Ansprüche 1 bis 3, **dadurch gekennzeichnet**, daß die erste Elektrode (6) in Form mehrerer beabstandeter, aber zusammenhängender Finger (20) ausgebildet ist und daß zwischen den Fingern jeweils ein Teil (19) der zweiten Elektrode (5) liegt.

5. Leistungsthyristor nach einem der Ansprüche 1 bis 3, **dadurch gekennzeichnet**, daß die erste Elektrode (6) aus einer Vielzahl von voneinander getrennten inselförmigen Bereichen gebildet ist.

6. Leistungsthyristor nach Anspruch 1, **dadurch gekennzeichnet**, daß die polykristalline Siliciumschicht (8) dotiert ist.

7. Leistungsthyristor nach Anspruch 6, **dadurch gekennzeichnet**, daß die polykristalline Siliciumschicht (8) eine Dotierstoffquelle für eine Emitterzone (4) ist.

**Claims**

1. Power thyristor with a semiconductor body having the features:

a) the semiconductor body has two main surfaces (13, 14) provided with metal electrodes,

b) at least two electrodes (5, 6) are arranged on at least one (14) of the main surfaces,

c) the contact surface (16) of the first (6) of these two electrodes lies in a first plane parallel to the main surface (14),

d) the contact surface (15) of the second (5) of these two electrodes lies in a second plane parallel to the main surface (14),

e) said main surface (14) is designed to be plane,

f) the contact surface (16) of the first electrode (6) is further away from the main surface (14) than the contact surface (15) of the second electrode (5),

g) the first electrode (6) consists of two layers (7, 8),

h) there is a metal layer (7) on the first layer (8) adjoining the main surface (14),

i) the metal layer (7) is made of the same metal and is the same thickness as the second electrode (5), characterized by the feature:

k) the first layer (8) adjoining the main surface (14) is made of polycrystalline silicon.

2. Power thyristor according to Claim 1, characterized in that the metal is aluminium.

3. Power thyristor according to Claim 1 or 2, characterized in that the main surface (14) and the second electrode (5) are covered with an insulating layer (9) of a polyimide and in that the insulating layer surrounds the first electrode (6) and leaves only its contact surface (16) free.

4. Power thyristor according to one of Claims 1 to 3, characterized in that the first electrode (6) is designed in the form of a plurality of spaced yet connected fingers (20), and in that in each case a part (19) of the second electrode (5) lies between the fingers.

5. Power thyristor according to one of Claims 1 to 3, characterized in that the first electrode (6) is formed from a plurality of insular areas separated from one another.

6. Power thyristor according to Claim 1, characterized in that the polycrystalline silicon layer (8) is doped.

7. Power thyristor according to Claim 6, characterized in that the polycrystalline silicon layer (8) is a doping material source for an emitter region (4).

**Revendications**

1. Thyristor de puissance comportant un corps semi-conducteur présentant les caractéristiques suivantes:

a) le corps semiconducteur comporte deux surfaces principales (13, 14) pourvues d'électrodes métalliques,

b) au moins deux électrodes (5, 6) sont disposées sur au moins l'une (14) des surfaces principales,

c) la surface de contact (16) de la première (6) de ces deux électrodes est située dans un premier plan parallèle à la surface principale (14),

d) la surface de contact (15) de la seconde (5) de ces deux électrodes est située dans un second plan parallèle à la surface principale (14);

e) ladite surface principale (14) est plane,

f) la surface de contact (16) de la première électrode (6) est plus éloignée de la surface principale (14) que la surface de contact (15) de la seconde électrode (5),

g) la première électrode (6) est formée de deux couches (7, 8),

h) une couche métallique (7) est disposée sur la première couche (8) jouxtant la surface principale (14), i) la couche métallique (7) est constituée par le même métal et possède la même épaisseur que la seconde électrode (5), caractérisé par la caractéristique suivante:

k) la première couche (8), qui jouxte la surface principale (14), est constituée par du silicium polycristallin.

2. Thyristor de puissance suivant la revendication 1, caractérisé par le fait que le métal est de l'aluminium.

3. Thyristor de puissance suivant la revendication 1 ou 2, caractérisé par le fait que la surface principale (14) et la seconde électrode (5) sont recouvertes par une couche isolante (9) formée d'un polyimide, que la couche isolante entoure la première électrode (6) et laisse dégager uniquement la surface de contact (16) de cette électrode.

4. Thyristor de puissance suivant l'une des revendications 1 à 3, caractérisé par le fait que la première électrode (6) est réalisée sous la forme de plusieurs doigts séparés, mais réunis (20) et que des parties respectives (19) de la seconde électrode (5) sont situées entre les doigts.

5. Thyristor de puissance suivant l'une des revendications 1 à 3, caractérisé par le fait que la première électrode (6) est formée par une multiplicité de zones en forme d'îlots, séparées les unes des autres.

6. Thyristor de puissance suivant la revendication 1, caractérisé par le fait que la couche de silicium polycristallin est dopée.

7. Thyristor de puissance suivant la revendication 6, caractérisé par le fait que la couche de silicium polycristallin (8) est une source de substance dopante pour une zone d'émetteur (4).

# FIG 1

K
15 16 7 12
10
9
4 14 5 6 4 2
8
1
13 3

A

# FIG 2

25 7 25 G
6 17
18 8 4 14 18 2
1

# FIG 3

6
19
20
5

# FIG 4

21
5
6

FIG 5

FIG 6

FIG 7

FIG 8

FIG 9

FIG 10